**Europäisches Patentamt**

**European Patent Office**

**Office européen des brevets**

(19)

(11) Veröffentlichungsnummer: **0 197 186**
**B1**

(12) ## EUROPÄISCHE PATENTSCHRIFT

(45) Veröffentlichungstag der Patentschrift:
**08.11.89**

(51) Int. Cl.⁴: **H 01 R 13/518, H 01 R 13/74**

(21) Anmeldenummer: **85110245.9**

(22) Anmeldetag: **16.08.85**

(54) Elektrische Steck- und/oder Schaltvorrichtung.

(30) Priorität: **27.03.85 DE 3511117**

(43) Veröffentlichungstag der Anmeldung:
**15.10.86 Patentblatt 86/42**

(45) Bekanntmachung des Hinweises auf die Patenterteilung:
**08.11.89 Patentblatt 89/45**

(84) Benannte Vertragsstaaten:
**AT BE CH DE FR GB IT LI LU NL SE**

(56) Entgegenhaltungen:
**DE-A- 2 907 049**
**DE-A- 3 146 125**
**DE-U- 8 310 120**
**US-A- 3 412 368**
**US-A- 4 220 391**
**US-A- 4 303 296**

(73) Patentinhaber: **Firma August Meyer, Bundesstrasse 36, D-4926 Dörentrup 3 (DE)**
Patentinhaber: **Uwe Dorn GmbH, Birkenallee 49, D-4930 Detmold 17 (DE)**

(72) Erfinder: **Piorek, Georg, Bahnhofstrasse 18, D-6200 Wiesbaden (DE)**

(74) Vertreter: **Hanewinkel, Lorenz, Dipl.-Phys., Patentanwalt Ferrariweg 17a, D-4790 Paderborn (DE)**

**Beschreibung**

Die Erfindung bezieht sich auf eine elektrische Steck- und/oder Schaltvorrichtung in Form einer in eine Arbeitsfläche einbaubaren, miteinander elektrisch verdrahtete Steckdosen und/oder Schalter aufweisenden Box.

Mehrfach-Steckdosenboxen zum Einbau in Arbeitsflächen, wie Schreibtischplatten od. dgl. sind bekannt und zeigen in einem haubenförmigen Gehäuse mehrere miteinander elektrisch verdrahtete Steckdosen und ggf. Schalter sowie elektrische Anschlüsse in Form von Steckverbindern (DE-U 83 101 209). Diese Box wird unter einer Arbeitsfläche im Bereich eines Ausschnittes durch Schrauben befestigt und dann obenseitig durch einen Abschlußrahmen überdeckt.

Da die Elektrifizierung am Arbeitsplatz immer mehr zunimmt und ständig mehr elektrische Anschlußmöglichkeiten erforderlich werden, insbesondere auch durch die Kommunikationsmittel reichen die bekannten Boxen nicht mehr aus und bedürfen einer Verbesserung.

Es ist deshalb Aufgabe der Erfindung, eine elektrische Steck- und/oder Schaltvorrichtung zu schaffen, die ein Gehäuse aufweist, in dem in einfacher Weise elektrisch verdrahtete Steckdosen-Schaltereinheiten der verschiedenen Ausführungen schnell und lagesicher und elektrisch abgesichert untergebracht sind und das ein nachträgliches Umrüsten der Steckdosen-Schaltereinheiten zuläßt.

Diese Aufgabe wird erfindungsgemäß durch die kennzeichnenden Merkmale des Patentanspruches 1 gelöst, wobei noch die in den Unteransprüchen 2 bis 8 aufgeführten Gestaltungsmerkmale vorteilhafte Weiterbildungen der Aufgabenlösung darstellen.

Weiterhin ist es Aufgabe der Erfindung, das Gehäuse der Vorrichtung so zu gestalten, daß es einerseits obenseitig bündig und verschlossen mit der Arbeitsfläche abschließt, einen gegenüber dem elektrischen Bereich abgeschlossenen Aufnahmebereich für Anschlußstecker und Kommunikationskabel zeigt und auf dem Arbeitsplatz vergossene Flüssigkeiten nicht in den elektrischen Bereich gelangen können.

Diese Aufgabenstellungen werden durch die Merkmale der Ansprüche 9 bis 13 gelöst.

Eine weitere Aufgabe der Erfindung liegt in einer einfachen, sicheren und leicht durchführbaren Befestigung des Gehäuses am Arbeitsplatz, welche durch die Merkmale der Ansprüche 14 bis 17 bei einfacher Montage gelöst wird.

Außerdem ist es Aufgabe der Erfindung, das Gehäuse der Steck- und/oder Schaltvorrichtung im es oben abschließenden Deckelbereich mit einer gegen Beschädigung gesicherten Kabeldurchführung auszustatten. Diese Aufgabe lösen die Merkmale der Ansprüche 19 und 20.

Der übrige bzw. alle Unteransprüche beinhalten Gestaltungsmerkmale, die zur Lösung der einen oder anderen Aufgabe beitragen.

Der Gegenstand der Erfindung erstreckt sich nicht nur auf die Merkmale der einzelnen Ansprüche, sondern auch auf deren Kombination.

Durch die Erfindung werden folgende Vorteile erzielt:

1. Die Steck- und/oder Schaltvorrichtung hat ein einfach aufgebautes Gehäuse, in dem elektrische verdrahtete Steckdosen-Schalter-Einheiten der verschiedenen Form herstellungsseitig und auch nachträglich einfach, schnell und sicher untergebracht werden können,

2. das Gehäuse besitzt eine innenliegende Trägerplatte, an der die Steckdosen-Schaltereinheiten in einem Ausschnitt durch Steck-, Rast- und/oder Schraubverbindung sicher lagefixiert sind und sich dabei im unteren Gehäusebereich in einem elektrisch abgeschlossenen Raum erstrecken,

3. der Raum im Gehäuse oberhalb der Trägerplatte nimmt die elektrischen Stecker auf und gleichzeitig Kommunikationskabel, die durch in Sollbruchstellen heraustrennbare Wandungsteile des Gehäuses geschaffene Öffnungen in diesen Raum hineingeführt werden können,

4. unter der Trägerplatte sind Steckbuchsen angeformt, an denen elektrische Anschlußklemmen oder elektrische Steckverbinder schraubenlos gehalten sind, die eine Verbindung mit aus dem Gehäuse herausführbare elektrischen Leitungen mit oder ohne Adapter und eine Steckverbindung mit gleichen Steckverbindern ermöglichen, also eine variable und vielseitige elektrische Verbindungsart,

5. das Gehäuse hat eine einfache und sichere sowie schnell durchführbare Befestigung im Bereich eines Ausschnittes unter einer Arbeitsfläche mittels eines winkelförmigen Rastorganes, welches in Nuten des Gehäuses höhenverstellbar geführt ist und unter der Arbeitsfläche verspannt in der Nut verrastet, so daß durch dieses Rastorgan die verschiedensten Stärken an Arbeitsplatten für die Gehäusebefestigung benutzt werden können,

6. in dem Gehäuse sind untenseitig Aufnahmewannen angeformt, in die herausnehmbare Flüssigkeitsbehälter eingesetzt sind – in diesen Behältern sammelt sich eventuell auf der Arbeitsfläche vergossene Flüssigkeit und kann nicht in den elektrischen Bereich gelangen; sollte das Entleeren der Behälter versäumt werden, so kann die Flüssigkeit durch die nach unten offenen Nuten für das Rastorgan aus dem Gehäuse dennoch herauslaufen, da die Behälter weiterhin durch einen den elektrischen Bereich überdeckenden Schutzbügel miteinander verbunden sind, kann auch bei abgenommenem Gehäusedeckel keine Flüssigkeit in den elektrischen Bereich gelangen,

7. die Oberseite des Gehäuses wird durch einen in sich ebenen Deckel verschlossen, der eine beliebige Randgestaltung haben kann und der auch abtrennbare Ränder für eine nahe Anordnung des Gehäuses am Arbeitsflächenrand hat bzw. hierfür entfallen kann, so daß der Auflagerand des Gehäuses direkt benutzt wird,

8. in dem Deckel sind für jede Steckdose Kabeldurchführöffnungen ausgespart, die durch eine im Bereich dieser Öffnungen eingerastet im Dekkel gehaltene und werkzeuglos, jedoch durch ein Hilfsmittel, wie Bleistift, Kugelschreiber od. dgl. herausnehmbare Schließplatte verschlossen ist,

9. diese Kabel-Durchführöffnungen werden dann von einem haubenförmigen Kabel-Durchführteil verschlossen, was, wie die Schließplatte, in der Öffnung lösbar gehalten ist, und welches einen Durchführkanal für das Kabel bildet und dieses gegen Beschädigung sichert,

10. die gesamte Vorrichtung ist einfach aufgebaut, leicht montierbar und hat durch ihre Variabilität einen hohen Gebrauchswert.

Anhand der Zeichnungen werden nachfolgend Ausführungsbeispiele gemäß der Erfindung näher erläutert. Es zeigt:

Fig. 1 einen senkrechten Längsschnitt durch ein langgestrecktes, obenseitig durch einen herausnehmbaren Deckel verschlossenes Gehäuse, in dem an einer innenliegenden Trägerplatte mehrere Steckdosen durch Schrauben lösbar festgelegt sind,

Fig. 2 einen senkrechten Längsschnitt durch ein langgestrecktes, dem Gehäuse nach Fig. 1 entsprechendes Gehäuse, in dem mehrere auf einem Unterteil gehaltene Steckdosen durch Rastverbindung im Bereich der Trägerplatte lösbar gehalten sind,

Fig. 3 einen senkrechten Längsschnitt durch das Gehäuse nach Fig. 1 mit am Gehäuse höhenverstellbar angeordneten Rastorganen für die Gehäusebefestigung an einer Arbeitsfläche,

Fig. 4 eine Draufsicht auf das Gehäuse mit obenseitigem Abschlußrahmen,

Fig. 5 einen senkrechten Querschnitt durch das Gehäuse mit beidseitigen Aufnahmewannen für Flüssigkeitsbehälter,

Fig. 6 eine Draufsicht auf den Abschlußrahmen gemäß Fig. 4 mit eingesetztem Deckel und aus diesem herausnehmbaren, Kabel-Durchführöffnungen überdeckenden Schließplatten,

Fig. 7 einen Querschnitt gemäß Schnittlinie I–I in Fig. 6 durch einen Teilbereich des Deckels mit eingesetzter Schließplatte,

Fig. 8 einen Querschnitt durch einen Teilbereich des Deckels bei herausgenommener Schließplatte und dafür eingesetztem Kabel-Durchführteil,

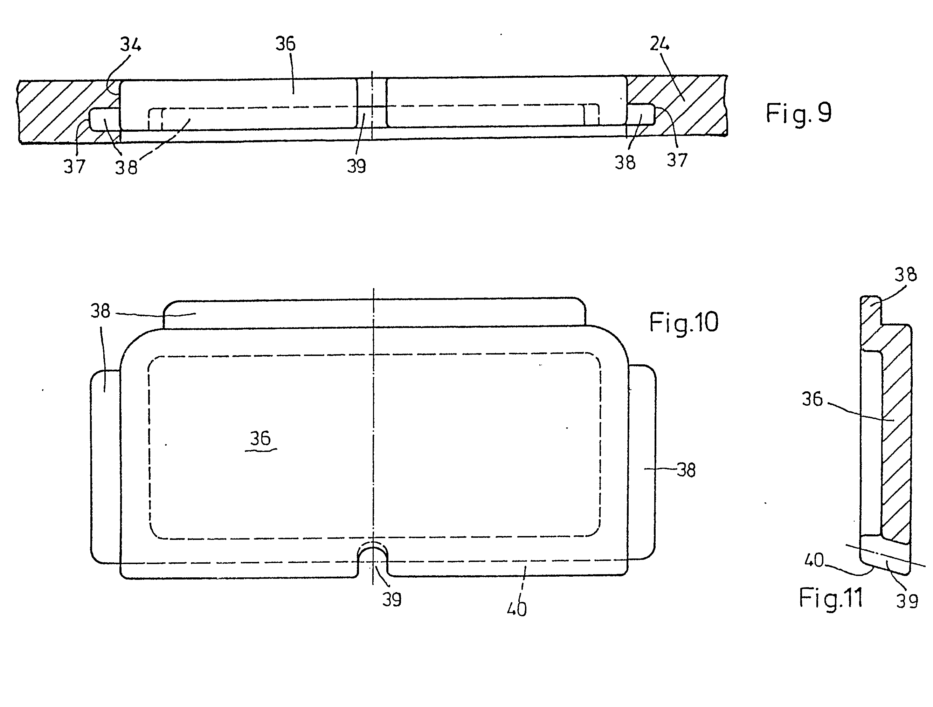

Fig. 9 bis 11 einen Längsschnitt, eine Draufsicht und einen Querschnitt durch die Schließplatte,

Fig. 12 bis 14 eine Vorderansicht, eine Draufsicht und einen Querschnitt durch das Kabel-Durchführteil,

Fig. 15 einen senkrechten Schnitt durch einen Längenendbereich des Gehäuses mit gegenüber Fig. 3 abgeänderter Ausführung,

Fig. 16 einen senkrechten Halbschnitt durch das Gehäuse nach Fig. 15 mit eingesetzten Flüssigkeitsbehältern in strich-punktierter Darstellung,

Fig. 17 bis 19 eine Seitenansicht, Vorderansicht und Draufsicht auf ein gegenüber Fig. 5 abgeändertes Rastorgan,

Fig. 20 bis 22 eine Stirnansicht, eine Seitenansicht und eine Draufsicht auf zwei durch einen Abdeckbügel miteinander verbundene Flüssigkeitsbehälter gemäß Fig. 16.

Mit 1 ist ein langgestrecktes einteiliges Gehäuse aus Kunststoff einer erfindungsgemäßen elektrischen Steck- und/oder Schaltvorrichtung bezeichnet, in dem mehrere Steckdosen 2, z.B. zwei, drei oder vier Steckdosen und/oder mindestens ein elektrischer Schalter lösbar festgelegt sind, wobei die Steckdosen 2 und Schalter in Gehäuse-Längsrichtung im Abstand zueinander und in Reihe angeordnet sind. Dieses Gehäuse 1 mit Steckdosen 2 und Schaltern bildet eine in eine Arbeitsfläche 3, wie Schreibtischplatte, einbaubare Box zur Elektrifizierung des Arbeitsplatzes.

Das Gehäuse 1 hat in bevorzugter Weise eine rechteckige Grundform und ist obenseitig offen, wobei an dieser offenen Gehäuseseite außenseitig ein vorstehender Auflagerand 4 umlaufend angeformt ist.

In dem Gehäuse 1 erstreckt sich eine angeformte, in sich ebene und einen Ausschnitt 5 zeigende Trägerplatte 6, die den Gehäuse-Innenraum in einen oberen und einen unteren Aufnahmeraum 7, 8 unterteilt. Diese Trägerplatte 6 erstreckt sich unterhalb der Höhenhalbierenden des Gehäuses 1.

An dieser Trägerplatte 6 werden die Steckdosen 2 und Schalter lösbar festgelegt, die dann in den unteren Aufnahmeraum 8 hineinragen, so daß der obere Aufnahmeraum 7 für die Stecker freibleibt.

Die in dieses Gehäuse 1 einzubauenden Steckdosen 2 und Schalter sind miteinander elektrisch verdrahtet.

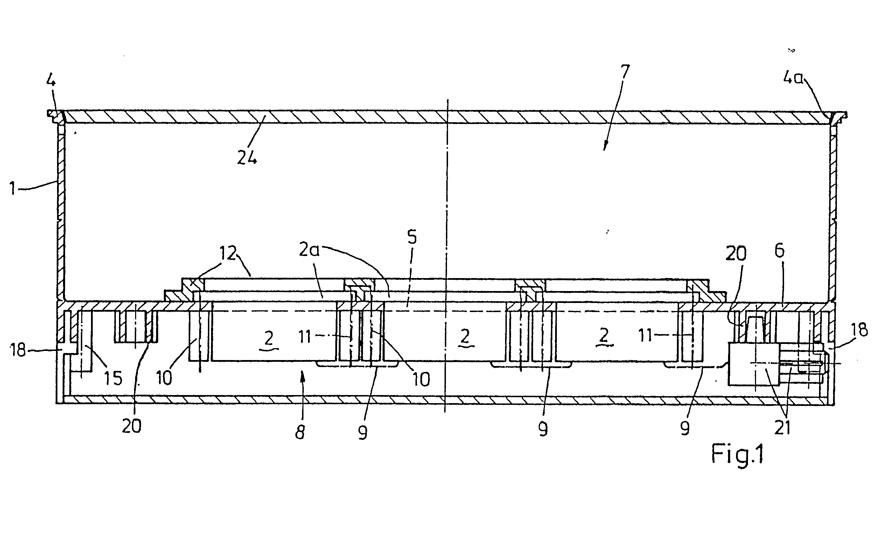

Bei der Ausführung des Gehäuses 1 nach Fig. 1, 3 und 4 werden die miteinander verdrahteten und somit durch die elektrischen Kabel 9 zusammenhängenden Steckdosen 2 und Schalter von unten her durch den Ausschnitt 5 oder von oben her durch den Ausschnitt 5 geführt und liegen dann mit ihren Steckdosen- bzw. Schalterrändern 2a auf der Trägerplatte 6 auf und ragen durch den Ausschnitt 5 nach unten in den Aufnahmeraum 8 hinein.

An der Unterseite der Trägerplatte 6 sind im umlaufenden Randbereich des Ausschnittes 5 nach unten gerichtete Auflage- und Befestigungshülsen 10 angeformt, die eine Befestigung der Steckdosen 2 und Schalter von unten her oder von oben durch Schrauben 11 ermöglichen. Diese Schrauben 11 werden von oben her durch Löcher in den Rändern 2a der Steckdosen 2 bzw. Schalter gesteckt und dann in die hohlen Hülsen 10 eingeschraubt. Das gleiche kann von unten erfolgen, indem dann die Schrauben 11 durch die Hülsen 10 gesteckt werden und in die Löcher der Ränder 2a eingeschraubt werden.

Die Steckdosen 2 und Schalter werden obenseitig von einem Rahmen 12 umgeben, der den freien Raum zwischen den Steckdosen 2 und dem Ausschnitt 5 in der Trägerplatte 6 überdeckt und sich auf die Trägerplatte 6 auflegt und an den Steckdosen 2 und Schaltern verrastet, so daß dann von oben her nur noch die Zugänge der Steckdosen 2 für die Stecker und die Betätigungsteile der Schalter freiliegen.

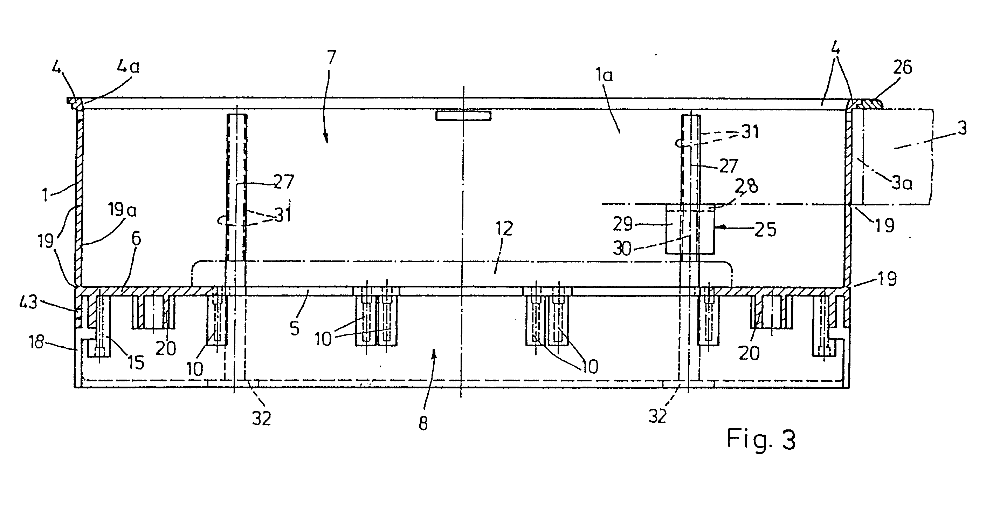

Dieser Rahmen 12 kann, wie in Fig. 3 in strichpunktierten Linien dargestellt, auch herstellungsseitig an die Trägerplatte 6 obenseitig angeformt sein.

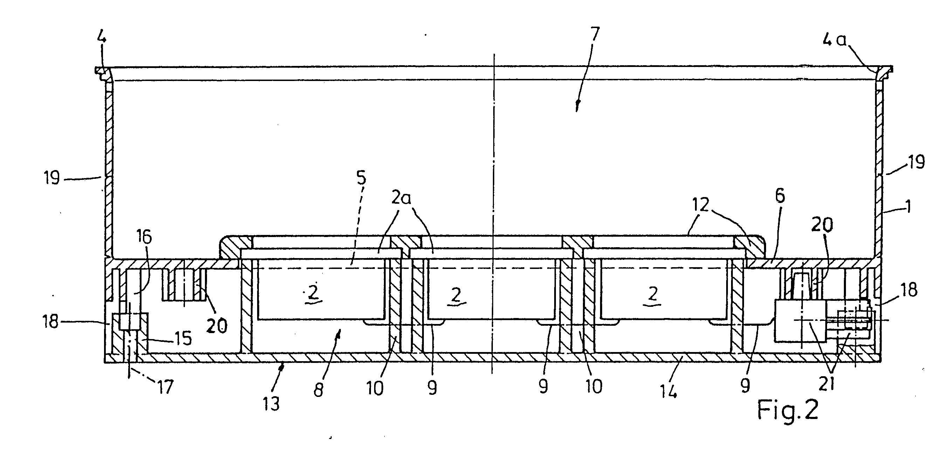

Gemäß der weiteren Ausführung nach Fig. 2 sind an der Unterseite der Trägerplatte 6 keine Hülsen 10 angeformt und die Festlegung der Steckdosen 2 und Schalter erfolgt hierbei von unten her durch ein zusätzliches Unterteil 13, welches eine in sich ebene Bodenplatte 14 aufweist, auf der sich nach oben hin mehrere Auflage- und Befestigungshülsen 10 angeformt abheben.

Die durch die elektrischen Kabel 9 miteinander verdrahteten Steckdosen 2 und Schalter werden mit ihren Rändern 2a auf die hohlen Hülsen 10 des Unterteiles 13 aufgesetzt und dann mit dem Unterteil 13 von unten her in das Gehäuse 1 eingeführt, wobei dann die Steckdosen 2 und Schalter durch den Ausschnitt 5 der Trägerplatte 6 mit ihren Rändern 2a nach oben hin fassen und mit dem separaten oder an die Trägerplatte 6 angeformten Rahmen 12 verrasten, so daß durch die Auflage der Steckdosen 2 mit ihren Rändern 2a auf den Hülsen 10 und die Verrastung mit dem Rahmen 12 eine Lagefixierung der Steckdosen 2 und Schalter ohne Schrauben erreicht worden ist. Es ist jedoch bevorzugt, zur Sicherheit noch zusätzlich eine Schraubbefestigung vorzunehmen, wobei dann die Schrauben durch die Löcher der Ränder 2a fassen und in die Hülsen 10 eingeschraubt sind.

Das Unterteil 13 wird mit seiner Bodenplatte 14 durch Steck- und Schraubverbindung mit dem Gehäuse 1 verbunden, wobei an der Bodenplatte 14 in den beiden Längenendbereichen nach oben gerichtete Buchsen 15 angeformt sind, die über an der Trägerplatte 6 angeformte, nach unten gerichtete Hülsen 16 fassen. Jeweils eine von unten her durch die Buchse 15 gesteckte Schraube 17 wird dann in die Hülse 16 eingeschraubt. In beiden Längenenden des Gehäuses 1 hat dieses jeweils eine mittige Aussparung 18 für die Einführung eines elektrischen Kabels oder für die Möglichkeit einer Steckverbindung. Im Abstand zu diesen Aussparungen 18 sind unter der Trägerplatte 6 Steckbuchsen 20 angeformt, in denen durch Steckverbindung entweder Anschlußklemmen für ein elektrisches Kabel oder elektrische Steckverbinder 21 lösbar festgelegt sind.

Bei der Anordnung von Anschlußklemmen wird ein elektrisches Kabel als Strom-Einspeisung oder als Verbindungsleitung durch die Aussparung 18 an die Anschlußklemme verlegt, wobei dieses elektrische Kabel außerhalb des Gehäuses 1 mit einem Adapter für den Anschluß an Stromverteilerschienen versehen sein kann.

Bei der Anordnung von elektrischen Steckverbindern 21 ist eine elektrische Verbindung zweier oder mehrerer Gehäuse 1 über die Steckverbindung der Steckverbinder 21 direkt oder unter Zwischenschaltung von Steckverbindern 21 und elektrischen Kabeln möglich – hierbei erfolgt die Steckverbindung ebenfalls im Bereich der Aussparung 18.

Die Steckverbinder 21 sind ebenfalls über Kabel 9 mit den Steckdosen 2 und Schaltern verdrahtet.

Durch dieses Gehäuse 1 erstrecken sich die elektrisch verdrahteten Teile 2 alle unterhalb der Trägerplatte 6 in dem unteren Aufnahmeraum 8 und sind somit nach oben hin zu dem Zugangsraum 7 des Gehäuses 1 abgeschirmt.

In den beiden Stirnwänden des Gehäuses 1 sind Sollbruchstellen 19 eingeformt, die einen Ausbruch von Wandungsteilen 19a zur Bildung von Einführöffnungen für Kommunikationskabel od. dgl. in den oberen Aufnahmeraum 7 ermöglichen.

Beiderseits des Ausschnittes 5 in der Trägerplatte 6 ist jeweils eine von der Trägerplatte 6 aus bis zur Gehäuse-Unterkante heruntergezogene Aufnahmewanne 22 in dem Gehäuse 1 eingeformt, die nach oben hin offen ist und sich über die gesamte Gehäuselänge erstreckt. In diesen beiden Aufnahmewannen 22 ist jeweils ein Flüssigkeitsbehälter 23 herausnehmbar und vorzugsweise formschlüssig einfassend eingesetzt. Sollte am Arbeitsplatz eine Flüssigkeit, wie Kaffee, Tee, Blumenwasser od. dgl. vergossen werden, so kann diese in das Gehäuse 1 hinein in die Flüssigkeitsbehälter 23 laufen und wird dort gesammelt. Da die beiden Aufnahmewannen 22 und die Trägerplatte 6 mit Rahmen 12 den unteren Aufnahmeraum 8 der verdrahteten Steckdosen 2 und Schalter abschirmen, kann die Flüssigkeit nicht in diesen elektrischen Bereich gelangen, so daß hierdurch eine große elektrische Sicherheit gewährleistet ist.

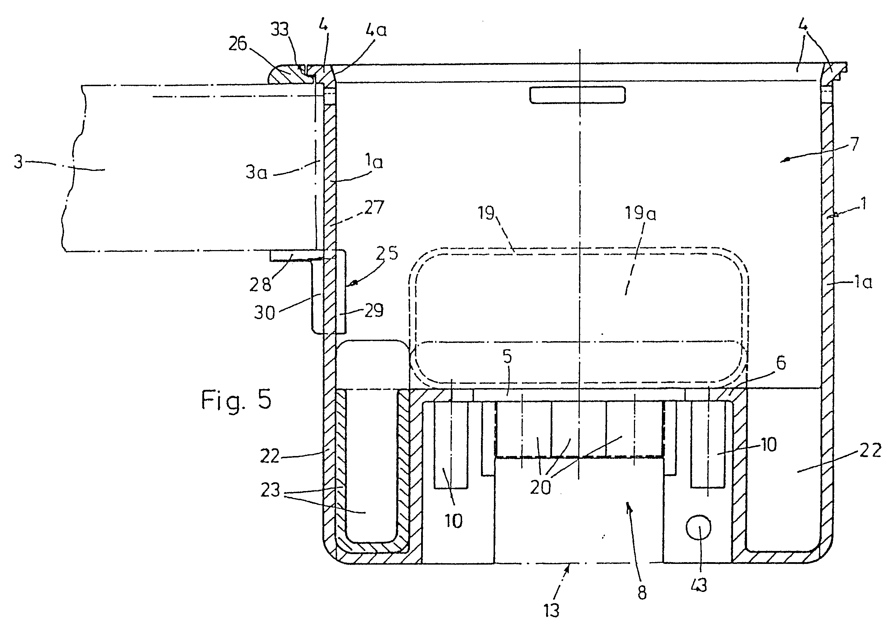

Das Unterteil 13 gemäß Fig. 2 ist in seiner Bodenplattenbreite so gehalten, daß es zwischen die beiden heruntergezogenen Wannen 22 gemäß Fig. 5 gesetzt wird und das Gehäuse 1 untenseitig mit den beiden Wannen 22 bündig abschließt. Der obenseitige, nach außen hervorstehende und umlaufende Auflagerand 4 hat eine zum Gehäuseinnern und nach unten hin verlaufende, vorzugsweise schräge Dichtfläche 4a, an die sich ein in die Gehäuseöffnung eingesetzter und die Gehäuseöffnung verschließender, herausnehmbarer Deckel 24 mit einer entsprechenden schrägen Randfläche anlegt. Der Deckel 24 schließt mit seiner Oberseite bündig mit der Oberseite des Auflagerandes 4 ab.

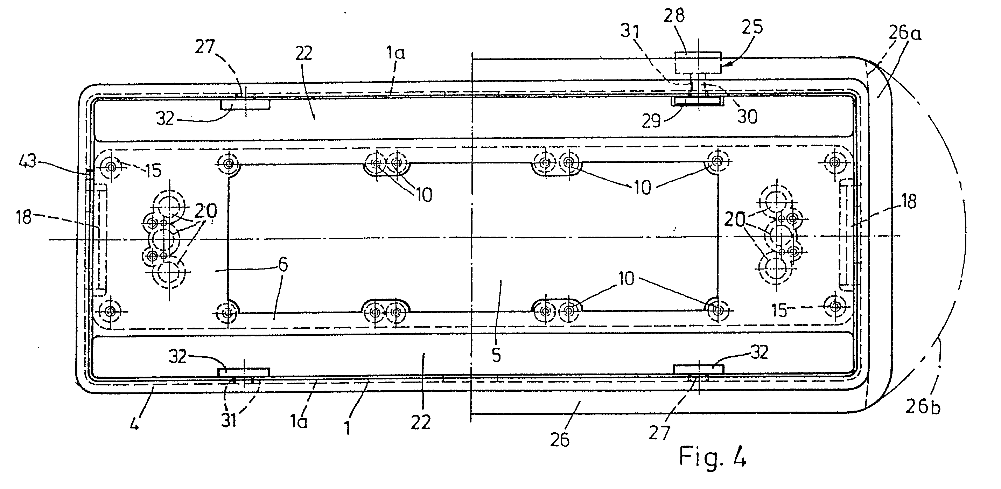

Das Gehäuse 1 wird in einem entsprechend großen Ausschnitt 3a der Arbeitsfläche 3 eingesetzt, wobei das Gehäuse 1 mit seinem Auflagerand 4 direkt auf der sich an den Ausschnitt 3a anschließenden Arbeitsfläche 3 aufliegen kann und dann durch von unten her auf die Arbeitsfläche 3 einwirkende Rastorgane 25 verspannt an der Arbeitsfläche 3 gehalten wird. Es ist jedoch bevorzugt, das Gehäuse 1 mit seinem Auflagerand 4 in einen umlaufenden Abschlußrahmen 26 unter Falzverbindung 33 einzusetzen, wobei die Oberseite beider Rahmen 4, 26 bündig verläuft. Dabei kann der Abschlußrahmen (Blendrahmen/Zierrahmen) 26 die verschiedensten Grundformen haben – er ist vorzugsweise entsprechend dem Gehäuse 1 rechteckig ausgebildet und zeigt an seinen beiden Querseiten gerade, gerundete (vgl. strichpunktierte Linie 26b in Fig. 4) oder eckige Randgestaltungen.

Um das Gehäuse 1 möglichst nahe an eine Kante (einen Rand) der Arbeitsfläche 3 anordnen zu können, kann entweder der Abschlußrahmen 26 weggelassen werden oder aber die der Arbeitsflächenkante benachbarte Rahmenseite 26a des Abschlußrahmens 26 wird abgetrennt oder weggelassen (vgl. Fig. 4).

Das Gehäuse 1 weist in seinen beiden Längswandungen 1a jeweils zwei im Abstand zueinander angeordnete, in Gehäuse-Höhenrichtung und somit senkrecht verlaufende Nuten 27 auf (vgl. Fig. 3), die sich von der Gehäuse-Unterkante bis in geringem Abstand zum obenseitigen Auflagerand 4 erstrecken. In jeder dieser Nuten 27 ist ein Rastorgan 25 höhenverstellbar geführt und arretiert. Jedes Rastorgan 25 ist von einem Winkel gebildet, dessen obenliegender waagerechter Schenkel eine mit der Unterseite der Arbeitsfläche 3 zusammenwirkende Spannfläche 28 bildet und dessen senkrechter Schenkel eine an der Innenseite der Gehäuse-Längswandung 1a anliegende Widerlagerfläche 29 ergibt. In der Draufsicht ist das Rastorgan 25 doppel-T-förmig ausgebildet, so daß zwischen Spannfläche 28 und Widerlagerfläche 29 ein Steg 30 vorhanden ist, der in seiner Breite der Breite der Nut 27 entspricht und in dieser höhenbeweglich verläuft – die beiden Flächen (Schenkel) 28, 29 des Rastorganes 25 sind breiter als die Nut 27 ausgeführt und ragen nach beiden Seiten über die Nut 27 hinaus. Der senkrechte Winkelschenkel 29 hat durch den Steg 30 einen H-Querschnitt.

An den sich gegenüberliegenden Flächen der Nut sind zahnartige Rastungen 31 vorgesehen, die mit zahnartigen Rastungen an den sich gegenüberliegenden Seiten des Steges 30 zusammenwirken. Dabei sind diese zahnartigen Rastungen 31 derart ausgebildet, daß sie ein Verschieben des Rastorganes 25 nach oben in die Spannstellung zulassen, jedoch ein Verschieben des Rastorganes 25 nach unten unterbinden, wodurch die eingerastete Spannstellung des Rastorganes 25 gesichert wird.

Die zahnartigen Rastungen 31 können auch an der Innenseite der Längswandung 1a und an der an dieser anliegenden Widerlagerfläche 29 vorgesehen sein.

Zum Einführen des Rastorganes 25 ist jede Nut 27 im unteren Endbereich (Boden der Wanne 22) entsprechend der Breite der Widerlagerfläche 29 als Einführschlitz 22 (vgl. Fig. 3 und 4) verbreitert.

Die Befestigung des Gehäuses 1 in einer Arbeitsfläche 3 geschieht folgendermaßen:

Das Gehäuse 1 wird von oben her in den der Größe des Gehäuses 1 entsprechenden und vorzugsweise geringfügig größer ausgeführten Ausschnitt 3a der Arbeitsfläche (-platte, Wandung) eingesetzt und legt sich dann mit seinem Auflagerand 4 direkt auf die Arbeitsfläche 3 auf oder aber in einen Falz 33 eines vorher auf die Arbeitsfläche 3 um den Ausschnitt 3a lose aufgelegten Abschlußrahmen 26 ein.

Danach wird das winkelförmige Rastorgan 25 in der Nut 27 so weit nach oben geschoben (von Hand), bis der waagerechte Spannschenkel 28 unter die Arbeitsfläche 3 zu liegen kommt. Nun wird noch ein weiterer Druck auf das Rastorgan 25 nach oben ausgeübt, daß der Spannschenkel 28 fest gegen die Arbeitsfläche drückt und dann die zahnartigen Rastungen 30 einrasten, wodurch die verspannte Befestigung des Gehäuses 1 mit der Arbeitsfläche 3 erreicht ist, da nämlich die Arbeitsfläche 3 zwischen Auflagerand 4 und Abschlußrahmen 26 und Spannschenkel 28 festgeklemmt ist – der aufrechte Widerlagerschenkel 29 liegt dabei ebenfalls unter Spannung an der Innenseite der Gehäuse-Längswandung 1a an.

Der herausnehmbar in den Auflagerand 4 des Gehäuses 1 eingesetzte Deckel 24 ist für jede Steckdose 2 mit einer Durchführöffnung 34 für ein elektrisches Kabel 35, und zwar das Kabel des Steckers, ausgestattet, welche jeweils durch eine herausnehmbare Schließplatte 36 verschlossen ist. Diese Schließplatte 36 ist in sich eben ausgebildet und schließt ebenfalls mit der Oberseite des Deckels 24 bündig ab.

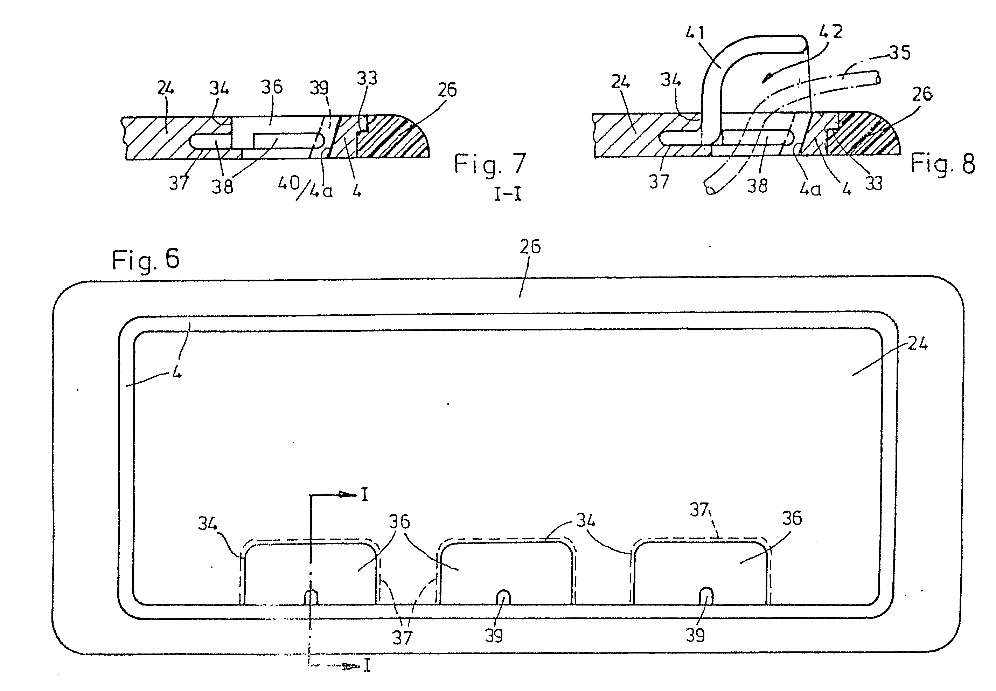

Die Schließplatte 36 hat vorzugsweise eine rechteckige Grundform und ist durch Nut-Verbindung eingerastet in dem Deckel 24 gehalten. Die Kabel-Durchführöffnungen 34 sind gemäß Fig. 6 in einem Längsrandbereich des Deckels 24 vorgesehen und von diesem Rand her werden die Schließplatten 36 eingeschoben bzw. herausgenommen. An der Schließplatte 36 sind dreiseitig vorstehende Stege 38 angeformt, die in entsprechende Nuten 37 des Deckels 24 einfassen. Die vierte, dem Auflagerand 4 benachbarte Seite, und zwar eine Längsseite der Schließplatte 36, ist ohne Steg 38 ausgestattet und weist dafür eine schräge Ein- und Ausführfläche 40 und eine Grifföffnung 39 für das Einführen eines Hilfsmittels, wie Bleistift, Kugelschreiber od. dgl. zum Herausnehmen der Schließplatte 36 aus dem Deckel 34 auf.

Die Schließplatte 36 wird vom Auflagerand 4 her schräg nach unten und in Richtung Deckelmitte eingesetzt, wobei die beiden seitlichen Stege 38 in die seitlichen Nuten 37 und der an der vorderen, der Öffnung 39 gegenüberliegenden Längsseite vorgesehene Steg 38 in die längsseitige Nut 37 der die Kabel-Durchführöffnung 34 begrenzenden Wandung des Deckels 24 eingeschoben und anschließend die Schließplatte 36 nach unten gedrückt wird, so daß sie in der Durchführöffnung 34 verrastet, indem sich die schräge Ein- und Ausführfläche 40 an die schräge Dichtfläche 4a des Auflagerandes 4 anlegt. Die Nuten 37 und die Stege 38 sind innerhalb der Wandstärken des Deckels 24 und der Schließplatte 36 vorgesehen.

Das Lösen der Schließplatte 24 erfolgt dadurch, daß ein Hilfsmittel (kein Werkzeug) in die Öffnung 39 eingesteckt und dann die Schließplatte 24 hochgehebelt wird, so daß sie schräg nach oben und entgegen der Einführung aus der Durchführöffnung 34 herausgenommen werden kann. Nun können die entsprechenden elektrischen Kabel 35 aus dem Gehäuse 1 heraus bzw. in dieses hinein durch die freigelegte Öffnung 34 verlegt werden.

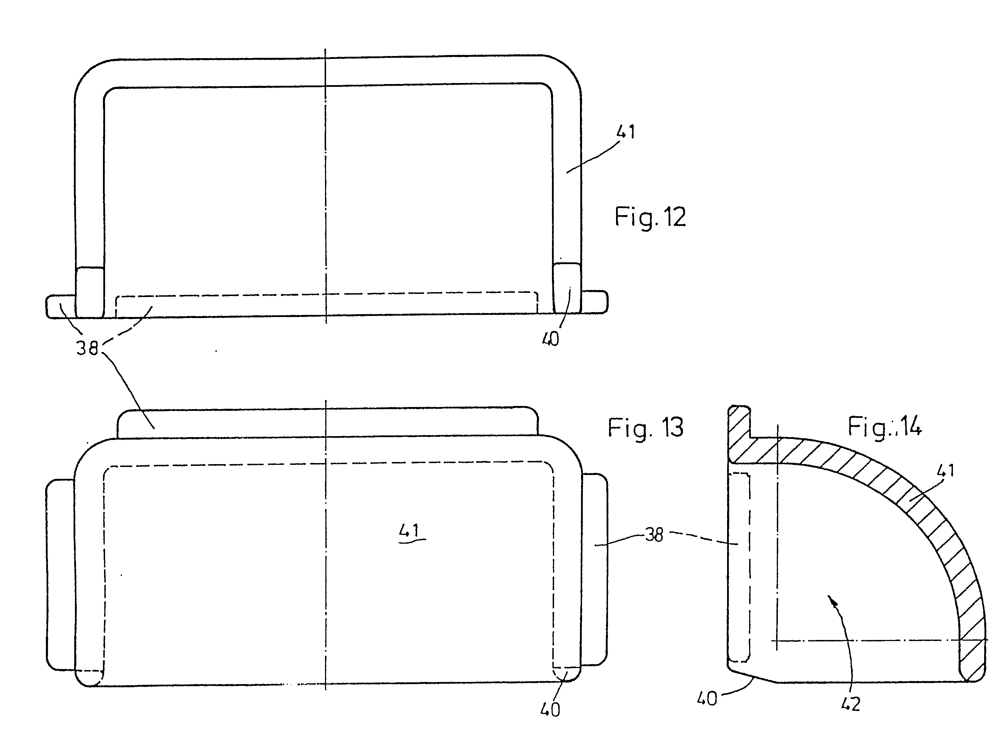

Um diese aus dem Gehäuse 1 herausgeführten und auf dem Deckel 24 liegenden elektrischen Kabel 35 gegen Beschädigung, beispielsweise durch Gegenstoßen mittels einer Schreibmaschine oder eines anderen schweren Gerätes, zu schützen, werden in die freigelegten Durchführöffnungen 34 Kabel-Durchführteile 41 gemäß Fig. 8 und 12 bis 14 eingesetzt. Jedes Durchführteil 41 ist von einer Schutzhaube gebildet, die sich nach oben hin vom Deckel 24 abhebt und drei Grundformseiten der Durchführöffnung 34 sowie die Durchführöffnung 34 nach oben hin mit Abstand überdeckt, so daß diese Schutzhaube 41 mit der Durchführöffnung 34 einen nach oben hin und zu der auflagerandseitigen Längskante des Deckels 24 offenen Durchführkanal 42 für das elektrische Kabel 35 bildet.

Diese Schutzhaube 41 ist entsprechend der Schließplatte 36 an drei Seiten mit den vorstehenden Stegen 38 und an den beiden Haubenseiten mit der schrägen Ein- und Ausführfläche 39 versehen, mit denen sie in die Nuten 37 des Deckels 24 und mit der sie sich an die schräge Dichtfläche 4a des Auflagerandes 4 einrastend einlegt.

Die Schließplatte 36 und das Kabel-Durchführteil 41 sind jeweils einteilig aus Kunststoff geformt. Die Schließplatten 36 sind nach dem Einbau der erfindungsgemäßen Vorrichtung Bestandteile derselben und schließen die Kabel-Durchführöffnungen 34 ab. Die später einzusetzenden Kabel-Durchführteile 41 gehören ebenfalls zu der Vorrichtung und sind in dem oberen Aufnahmeraum 7 des Gehäuses 1 für den späteren Gebrauch untergebracht.

Das Gehäuse 1 ist an mindestens einer Stirnseite im Bereich der unteren Aufnahmekammer 8 mit einem von außen zugänglichen Erdungsanschluß 43 ausgestattet (Fig. 3, 4 und 5).

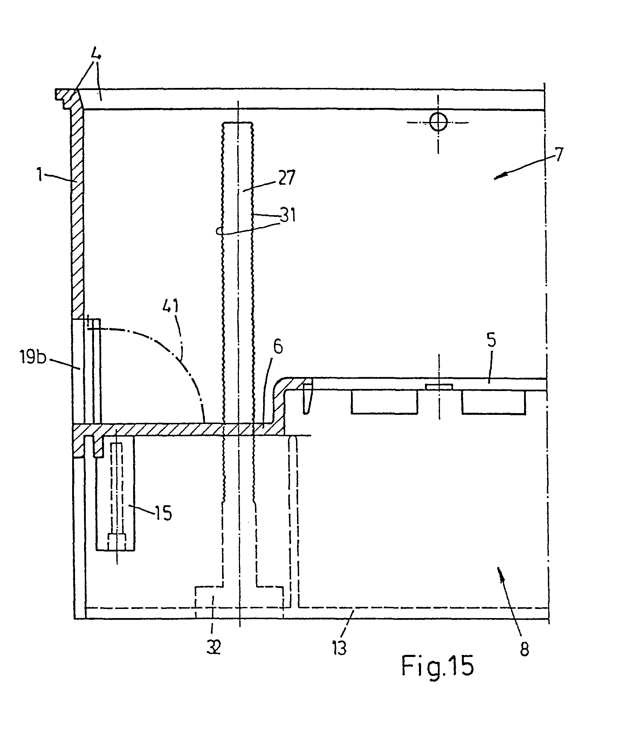

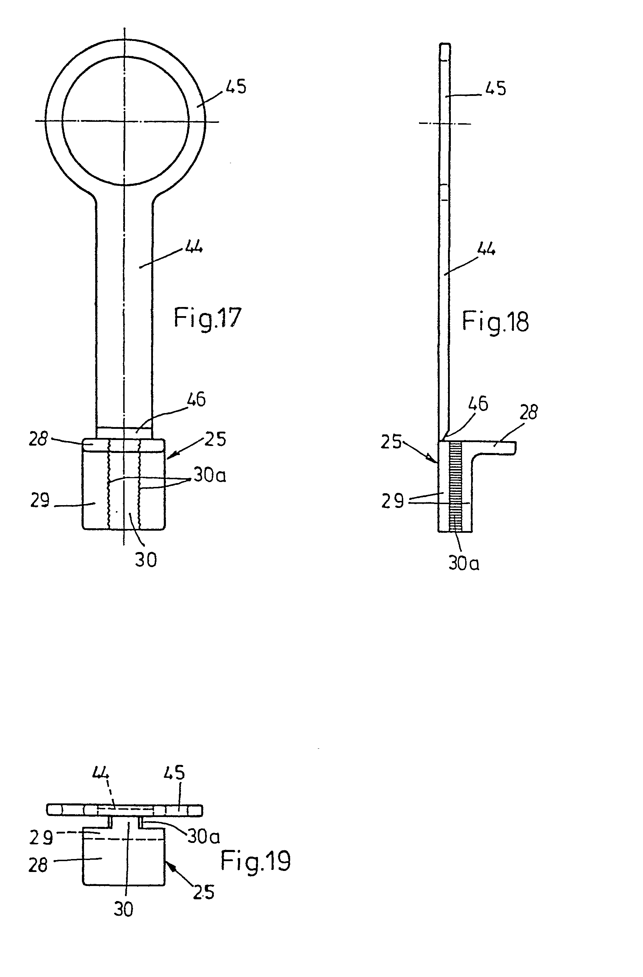

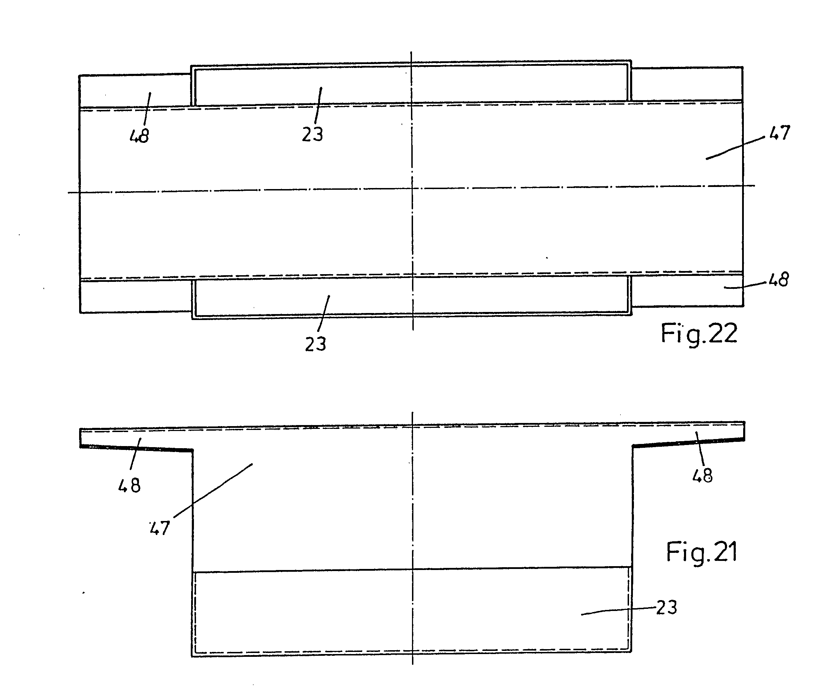

Die in den Figuren 15 bis 22 dargestellten weiteren Ausführungen des Gehäuses 1, des Rastorgans 25 und der Flüssigkeitsbehälter 23 entsprechen im Grundaufbau und in der Funktion den bereits beschriebenen Ausführungen, so daß für dieselben Teile auch dieselben Bezugszahlen verwendet werden und lediglich auf die Abänderungen nachfolgend näher Bezug genommen wird.

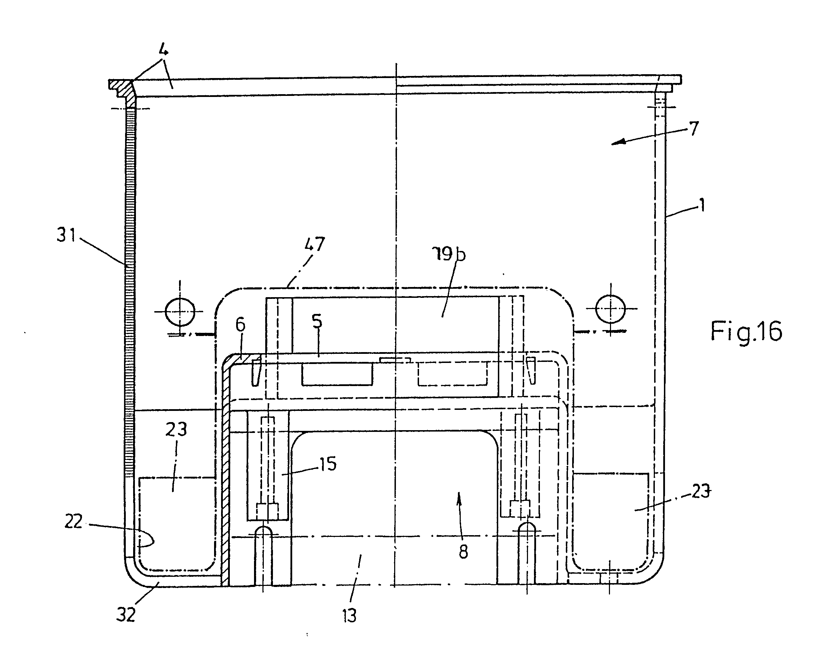

Bei dem Gehäuse 1 nach Fig. 15 und 16 ist in den beiden sich gegenüberliegenden Stirnwandungen jeweils eine Einführöffnung 19b für Kommunikationskabel ausgespart, die sich an die Trägerplatte 6 anschließen, nach oben hin erstrecken und somit im oberen Aufnahmeraum 7 liegen. Diese Einführöffnungen 19b sind durch je eine Schließplatte 36 verschließbar. Des weiteren kann bei Herausnahme der Schließplatte 36 eine Schutzhaube 41 eingesetzt werden, die dann mit ihrem Durchführkanal 42 nach oben oder unten zu den beiden Räumen 7, 8 zeigt und dementsprechend die Kommunikationskabel geschützt geführt werden. Die Befestigung der Schließplatte 36 bzw. Schutzhaube 41 erfolgt wie bei der Ausführung nach Fig. 7 und 8.

Das Rastorgan 25 gemäß der weiteren Ausführung nach Fig. 17 bis 19 ist mit einem abtrennbaren Einführ- und Zugsteg 44 mit Griffring 45 ausgestattet. Der Einführ- und Zugsteg 44 erstreckt sich dabei in senkrechter Verlängerung der Widerlagerfläche 29 und ist an dem diese Fläche 29 bildenden senkrechten Schenkel über eine Sollbruchstelle 46 abtrennbar mit einem Längenende gehalten; am anderen Längenende hat der Steg 44 den Griffring 45.

Durch diesen Einführ- und Zugsteg 44 mit Griffring 45 kann das Rastorgan 25 von oben her in das Gehäuse 1 nach unten hin gesteckt werden und zwar so weit, bis der waagerechte Schenkel 28 durch die untenseitige Einführöffnung 32 hindurch kann und dabei der Steg 30 in die Nut 27 gelangt. Dann wird das Rastorgan 25 durch den Steg 44 mit Griffring 45 nach oben hochgezogen und das Rastorgan 25 mit seinem waagerechten Schenkel 28 unter der Arbeitsplatte 3 verspannt. Nun läßt sich der Steg 44 im Bereich der Sollbruchstelle 46 vom Rastorgan 25 abtrennen.

Dieses Rastorgan mit Einführ- und Zugsteg 44 und Griffring 45 erleichtert wesentlich die Gehäusebefestigung in der Arbeitsfläche 3, da diese von oben her und innerhalb des Gehäuses 1 schnell und mühelos erfolgen kann und dennoch sicher ist.

Mit 30a sind Verzahnungen od. dgl. am Steg 30 bezeichnet, die mit den Verzahnungen 31 der Nut 27 im Gehäuse 1 zusammenwirken.

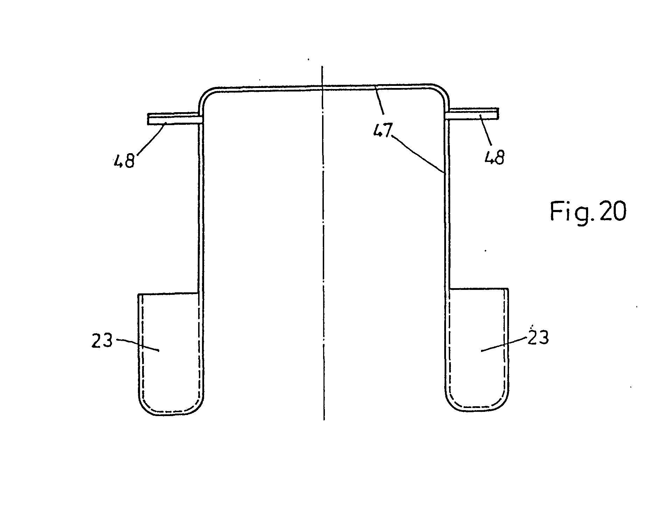

Gemäß der Ausführung nach Fig. 20 bis 22 sind die beiden Behälter 23 zum Auffangen von in das Gehäuse 1 eventuell eindringenden Flüssigkeiten durch einen U-förmigen Schutzbügel 47 miteinander zu einer Einheit verbunden, der im eingesetzten Zustand der beiden Behälter 23 (jeder in einer Wanne 22) die Trägerplatte 6 im Bereich der befestigten Steckdosen und/oder Schalter 2 überdeckt, so daß auch bei abgenommenem Gehäusedeckel 24 in das Gehäuse 1 eindringende Flüssigkeit nicht in den elektrischen Bereich gelangen kann, sondern über den Schutzbügel 47 zu den Behältern 23 hin abfließt.

Der Schutzbügel 47 erstreckt sich mindestens über die gesamte Länge der beiden Behälter 23, ist vorzugsweise endseitig über die Behälter 23 hinausgeführt und zeigt oberhalb der Behälter 23 endseitige Schutzstege 48.

Das nach unten offene Gehäuse 1 läßt sich durch einen darin einfassenden, haubenartigen Boden 13 verschließen gemäß Fig. 16.

## Patentansprüche

1. Elektrische Steck- und/oder Schaltvorrichtung in Form einer in eine Arbeitsfläche einbaubaren Box zur Elektrifizierung des Arbeitsplatzes, mit einem mehrere miteinander elektrisch verdrahtete Steckdosen (2) und/oder Schalter aufweisenden, langgestreckten Gehäuse (1), dadurch gekennzeichnet, daß in dem Gehäuse (1) eine den Gehäuse-Innenraum in einen oberen und einen unteren Aufnahmeraum (7, 8) unterteilende Trägerplatte (6) einstückig angeformt ist, die in einem Ausschnitt (5) die in den unteren Aufnahmeraum (8) hineinragenden, elektrisch abgeschirmten, zum oberen Aufnahmeraum (7) hin bis auf ihre Zugänge von einem auf der Trägerplatte (6) aufliegenden Rahmen (12) überdeckten Steckdosen (2) und/oder Schalter durch Steck-, Rast- und/oder Schraubverbindung lagefixiert lösbar hält, und

daß an der geöffneten, einen Zugang zu den im oberen Aufnahmeraum (7) untergebrachten elektrischen Stecker für die Strom- und Kommunikationsabnahme bildende Gehäuseseite ein außenseitig mindestens teilweise umlaufender Auflagerand (4) einstückig angeformt ist, mit dem die Box in einem Arbeitsflächen-Ausschnitt (3a) gehalten ist.

2. Steck- und/oder Schaltvorrichtung nach Anspruch 1, dadurch gekennzeichnet, daß die Trägerplatte (6) in sich eben ausgebildet und unterhalb der Höhenhalbierenden des eine rechteckige Grundform aufweisenden Gehäuses (1) angeordnet ist.

3. Steck- und/oder Schaltvorrichtung nach den Ansprüchen 1 und 2, dadurch gekennzeichnet, daß im Umfangsrand des Ausschnittes (5) an der Trägerplatte (6) nach unten abstehende Auflage- und Befestigungshülsen (10) angeformt sind, auf den sich die elektrisch verdrahtete Steckdosen-Schaltereinheit (2) von oben oder von unten her durch den Ausschnitt (5) eingeführt mit ihren Rändern (2a) abstützt und durch Löcher der Ränder (2a) und in die Hülsen (10) einfassender Schrauben (11) lösbar auf der Trägerplatte (6) befestigt ist, wobei der nach oben über die Trägerplatte (6) vorstehende Bereich der Steckdosen-Schaltereinheit (2) durch einen mit dieser Einheit verrasteten Rahmen (12) bis auf die Zugangsöffnungen und Betätigungsteile abgedeckt ist (Fig. 1).

4. Steck- und/oder Schaltvorrichtung nach den Ansprüchen 1 und 2, dadurch gekennzeichnet, daß die elektrisch verdrahtete Steckdosen-Schaltereinheit (2) mit einem separaten, diese Einheit (2) aufnehmenden Unterteil (13) von unten her in das Gehäuse (1) eingesetzt und durch Steck- und/oder Rastverbindung in dem Gehäuse (1) lösbar festgelegt ist, wobei der nach oben durch den Ausschnitt (5) der Trägerplatte (6) hinausragende Bereich der Steckdosen-Schaltereinheit (2) durch einen mit dieser Einheit (2) verrasteten Rahmen (12) bis auf die Zugangsöffnungen und Betätigungsteile abgedeckt ist (Fig. 2).

5. Steck- und/oder Schaltvorrichtung nach Anspruch 4, dadurch gekennzeichnet, daß das Unterteil (13) eine in das Gehäuse (1) untenseitig bündig einfassende Bodenplatte (14) aufweist, auf der sich mehrere nach oben gerichtete, angeformte Auflage- und Befestigungshülsen (10) abheben, auf denen die Schalter und Steckdosen (2) mit ihren Rändern (2a) aufliegen und ggf. durch Schrauben festgelegt sind.

6. Steck- und/oder Schaltvorrichtung nach Anspruch 4 und 5, dadurch gekennzeichnet, daß das Unterteil (13) mit an seiner Bodenplatte (14) angeformten, nach oben gerichteten, endseitig vorgesehenen Buchsen (15) über an der Trägerplatte (6) nach unten angeformte Hülsen (16) faßt und durch in diese Buchsen (15) und Hülsen (16) eingreifende Schrauben (17) lösbar im Gehäuse (1) gehalten ist.

7. Steck- und/oder Schaltvorrichtung nach Anspruch 3 und 4, dadurch gekennzeichnet, daß die von unten her in den Ausschnitt (5) der Trägerplatte (6) einsetzbare oder die auf dem Unterteil (13) angeordnete, ebenfalls von unten her in den Trägerplatten-Ausschnitt (5) einsetzbare Steckdosen-Schaltereinheit (2) von einem auf der Oberseite der Trägerplatte (6) angeformten Rahmen (12) überdeckt ist (Fig. 3).

8. Steck- und/oder Schaltvorrichtung nach den Ansprüchen 1 bis 7, dadurch gekennzeichnet, daß an der Unterseite der Trägerplatte (6) in beiden Gehäuse-Längenendbereichen mehrere Buchsen (20) angeformt sind, in denen elektrische Anschlußklemmen oder elektrische Steckverbinder (21) durch Steckverbindung lösbar gehalten sind und daß das Gehäuse (1) in seinen beiden Stirnseiten im Bereich dieser Anschlußklemmen bzw. Steckverbinder (21) jeweils eine Zugangsöffnung (18) für den Anschluß einer elektrischen Leitung bzw. eines zweiten Steckverbinders (21) aufweist (Fig. 1 bis 3).

9. Steck- und/oder Schaltvorrichtung nach den Ansprüchen 1 bis 8, dadurch gekennzeichnet, daß die oben offene Gehäuseseite durch einen herausnehmbaren Deckel (24) verschlossen ist, der in eine schräg nach unten und zum Gehäuse-Aufnahmeraum (7) hin gerichtete Dichtfläche (4a) des Auflagerandes (4) formschlüssig und mit dem Auflagerand (4) obenseitig bündig abschließend einfaßt (Fig. 1).

10. Steck- und/oder Schaltvorrichtung nach den Ansprüchen 1 bis 9, dadurch gekennzeichnet, daß das Gehäuse (1) an seinen beiden Stirnseiten mit Sollbruchstellen (19) zum Heraustrennen von Wandungsteilen (19a) und Bildung von Öffnungen (19b) für die Einführung von Kommunikationskabeln in den oberen Aufnahmeraum (7) aufweist (Fig. 2, 3, 5, 15, 16).

11. Steck- und/oder Schaltvorrichtung nach Anspruch 10, dadurch gekennzeichnet, daß die im Anschluß an die Trägerplatte (6) sich nach oben hin erstreckende Öffnung (19b) durch eine lösbare Schließplatte (36) verschließbar oder durch eine lösbar eingesetzte Schutzhaube (41) nach oben oder unten im Gehäuse (1) weitergeführt ist (Fig. 15).

12. Steck- und/oder Schaltvorrichtung nach den Ansprüchen 1 bis 11, dadurch gekennzeichnet, daß in beiden Längsseiten des Gehäuses (1) im Anschluß an die Trägerplatte (6) nach unten hin jeweils eine die gesamte Höhe und Länge des unteren Aufnahmeraumes (8) einnehmende nach oben hin zum oberen Aufnahmeraum (7) hin offene Aufnahmewanne (22) angeformt ist, in die jeweils ein Flüssigkeiten aufnehmender Behälter (23) herausnehmbar und vorzugsweise formschlüssig eingesetzt ist (Fig. 4 und 5).

13. Steck- und/oder Schaltvorrichtung nach Anspruch 12, dadurch gekennzeichnet, daß die beiden Behälter (23) durch einen U-förmigen, die elektrischen Teile (2) an der Trägerplatte (6) flüssigkeitsabweisend überdeckenden Schutzbügel (47) im Abstand zueinander gehalten und miteinander verbunden sind (Fig. 16 und 20 bis 22).

14. Steck- und/oder Schaltvorrichtung nach den Ansprüchen 1 bis 13, dadurch gekennzeichnet, daß in den beiden sich gegenüberliegenden Längswandungen (1a) des Gehäuses (1) jeweils mindestens zwei im Abstand zueinander in Höhenrichtung verlaufende, von der Gehäuse-Unterkante aus bis nahe dem Auflagerand (4) sich erstreckende Nuten (27) ausgespart sind, in denen ein winkelförmiges Rastorgan (25) höhenverstellbar und in der eingestellten Höhenlage verrastend geführt ist, welches eine verspannte Befestigung des in einen Ausschnitt (3a) der Arbeitsfläche (3) eingesetzten Gehäuse (1) zwischen auf der Arbeitsfläche (3) aufliegenden Auflagerand (4) und dem unter die Arbeitsfläche (3) drückenden Rastorgan (25) ergibt (Fig. 3, 4 und 5).

15. Steck- und/oder Schaltvorrichtung nach Anspruch 14, dadurch gekennzeichnet, daß jedes Rastorgan (25) von einem Winkelteil gebildet ist, dessen waagerechter Winkelschenkel (28) einen unter die Arbeitsfläche (3) einwirkenden Spannschenkel und dessen senkrechter Winkelschenkel (29) einen an der Gehäuse-Längswandung (1a) innenseitig anliegenden Widerlagerschenkel bildet, und zwischen beiden Schenkeln (28, 29) ein die Nut (27) durchgreifender Steg (30) vorgesehen ist.

16. Steck- und/oder Schaltvorrichtung nach Anspruch 14 und 15, dadurch gekennzeichnet, daß an den sich gegenüberliegenden Nutseiten zahnartige Rastungen (31) vorgesehen sind, die mit zahnartigen Rastungen des Steges (30) derart zusammenwirken, daß sie eine Verschiebebewegung des Rastorganes (25) nach oben in die Spann- und Befestigungsstellung zu lassen und eine Bewegung nach unten sperren.

17. Steck- und/oder Schaltvorrichtung nach den Ansprüchen 14 bis 16, dadurch gekennzeichnet, daß das Rastorgan (25) in Verlängerung seines senkrechten Winkelschenkels (29) einen abtrennbaren Einführ- und Zugsteg (44) mit Griffring (45) zur Rastorganbefestigung von oben und von der Gehäuseinnenseite her aufweist (Fig. 17 bis 19).

18. Steck- und/oder Schaltvorrichtung nach den Ansprüchen 1 bis 17, gekennzeichnet durch einen separaten, auf die Arbeitsfläche (3) auflegbaren Abschlußrahmen (26), in den sich der Auflagerand (4) des Gehäuses (1) unter Falzverbindung (33) bündig einlegt, wobei dieser Abschlußrahmen (26) eine dem Gehäuse (1) entsprechende rechteckige Grundform hat und an sich gegenüberliegenden Grundformseiten, geradlinige, bogenförmig (26b) oder eckige Formränder hat (Fig. 3 bis 5).

19. Steck- und/oder Schaltvorrichtung nach den Ansprüchen 1 bis 17, dadurch gekennzeichnet, daß im Deckel (24) für jede im Gehäuse (1) untergebrachte Steckdose (2) eine in einem Deckelrandbereich angeordnete Kabel-Durchführöffnung (34) ausgespart ist, die durch eine unter Rastverbindung eingesetzte herausnehmbare und durch ein haubenförmiges Kabel-Durchführteil (41) ersetzbare Schließplatte (36) verschlossen ist (Fig. 8 bis 14), wobei die in sich ebene Schließplatte (36) mit an drei Grundformseiten vorgesehenen Stegen (38) in Nuten (37) des Deckels (24) gehalten ist und an ihrer vierten Grundformseite eine schräge Einführ- und Herausführfläche (40) sowie eine Grifföffnung (39) für ein Hilfsmittel zum Herausnehmen der Schließplatte (36) aufweist (Fig. 9 bis 11).

20. Steck- und/oder Schaltvorrichtung nach Anspruch 19, dadurch gekennzeichnet, daß das haubenförmige Kabel-Durchführteil (41) die Kabeldurchführöffnung (34) bis auf einen auflagerandseitigen Kabel-Durchführkanal (42) allseitig überdeckt und mit Stegen (38) in den Nuten (37) des Deckels (24) herausnehmbar gehalten ist und kabeldurchführkanalseitig eine Einführ- und Herausführfläche (40) hat (Fig. 12 bis 14).

21. Steck- und/oder Schaltvorrichtung nach den Ansprüchen 1 bis 20, dadurch gekennzeichnet, daß das Gehäuse (1), der Abschlußrahmen (26), der Deckel (24), die Schließplatte (36) und das Kabel-Durchführteil (41) jeweils einteilig aus Kunststoff bestehen und in mindestens einer Gehäuse-Stirnwandung ein von außen zugänglicher Erdungsanschluß (43) angeordnet ist (Fig. 3 bis 5).

**Claims**

1. Electrical plug-in and/or switching device in the form of a box which can be built into an operational surface for electrification of the workstation, with a long housing (1) having a plurality of socket-outlets (2) and/or switches wired together electrically, characterised in that a carrier plate (6) is formed in one piece in the housing (1) and sub-divides the interior of said housing into an upper and a lower receiving area (7, 8), said carrier plate (6) holding in a cutout (5), in a positionally fixed, removable manner, by means of plug-in, interlocking and/or screwed connection, the socket-outlets (2) and/or switches which project into the lower receiving area (8), are electrically screened, and up to the upper receiving area (7) are masked, apart from their accesses, by a frame (12) which is supported on the carrier plate (6), and

that on the open side of the housing, providing access to the electrical plugs accommodated in the upper receiving area (7) for the collection of current and communications, there is formed in one piece a support rim (4) which is at least partly circumferential on the outside, and by means of which the box is held in a cutout (3a) in the operational surface.

2. Plug-in and/or switching device according to claim 1, characterised in that the carrier plate (6) is planar per se and is disposed below the elevational bisector of the housing (1) having a rectangular basic form.

3. Plug-in and/or switching device according to claims 1 and 2, characterised in that downwardly protruding support and attachment sleeves (10) are formed in the circumferential rim of the cutout (5) on the carrier plate (6), the electrically wired socket-outlet switch unit (2) being inserted through the cutout (5) from above or from below with its edges (2a) supported on said sleeves (10) and being removably attached to the carrier plate (6) by holes in the rims (2a) ans screws (11) which grip into the sleeves (10), the region of the socket-outlet switch unit (2) that projects upwardly past the carrier plate (6) being covered, apart from the access openings and actuating parts, by a frame (12) which interlocks with said unit (Fig. 1).

4. Plug-in and/or switching device according to claims 1 and 2, characterised in that the electrically wired socket-outlet switch unit (2) is inserted from below into the housing (1) with a separate bottom part (13) which receives said unit (2), and is removably fixed in the housing (1) by plug-in and/or interlocking connection, the region of the socket-outlet switch unit (2) that projects upwardly through the cutout (5) of the carrier plate (6) being masked, apart from the access openings and actuating parts, by a frame (12) interlocking with said unit (2) (Fig. 2).

5. Plug-in and/or switching device according to claim 4, characterised in that the bottom part (13) has a baseplate (4) which engages flush in the housing (1) on the bottom side, a plurality of upwardly directed, moulded support and attachment sleeves (10) rising from said baseplate (14), and the switches and socket-outlets (2) resting by their rims (2a) on said support and attachment sleeves (10) and, if appropriate, fixed with screws.

6. Plug-in and/or switching device according to claim 4 and 5, characterised in that the bottom part (13) grips, by sockets (16) formed on its baseplate (14), said sockets being upwardly directed and provided on the end faces, via sleeves (16) downwardly formed on the carrier plate (6), and the said bottom part (13) is removably held in the housing (1) by screws (17) which engage in said sockets (15) and sleeves (16).

7. Plug-in and/or switching device according to claim 3 and 4, characterised in that the socket-outlet switch unit (2) which can be inserted from below into the cutout (5) of the carrier plate (6) or arranged on the bottom part (13) and likewise insertable from below into the carrier plate cutout (5) is covered by a frame (12) formed on the top of the carrier plate (6) (Fig. 3).

8. Plug-in and/or switching device according to claims 1 to 7, characterised in that on the lower face of the carrier plate (6) in both longitudinal end portions of the housing are formed a plurality of sockets (20), in which electrical supply terminals or electrical plug connectors (21) are removably held by plug-in connection, and that in both its end faces, in the region of these supply terminals or plug connectors (21), the housing (1) has in each case an access opening (18) for connecting an electric cable or a second plug connector (21) (Figs. 1 to 3).

9. Plug-in and/or switching device according to claims 1 to 8, characterised in that the side of the housing that is open at the top is sealed by a removable lid (24), which fits positively into a downwardly sloping sealing face (4a) of the support rim, directed towards the receiving area (7) of the housing, and fits snugly with the support rim (4) and flush on the top side (Fig. 1).

10. Plug-in and/or switching device according to claims 1 to 9, characterised in that on both its end faces the housing (1) has rupture joints (19) for pressing out wall portions (19a) and forming openings (19b) for the introduction of communication cables into the upper receiving area (7) (Figs. 2, 3, 5, 15, 16).

11. Plug-in and/or switching device according to claim 10, characterised in that the upwardly extending opening (19b) adjoining the carrier plate (6) can be obturated by a removable closure plate (36) or continues through a removably inserted protective cap (41) upwards or downwards in the housing (1) (Fig. 15).

12. Plug-in and/or switching device according to claims 1 to 11, characterised in that in both long sides of the housing (1) adjoining the carrier plate (6) there is downwardly formed a receiving through (22) which occupies the total height and length of the lower receiving area (8) and is upwardly open up to the upper receiving area (7), and into said receiving through (22) there is removably inserted, preferably in positively interlocking fashion, a tank (23) which receives fluids (Figs. 4 and 5).

13. Plug-in and/or switching device according to claim 12, characterised in that the two tanks (23) are held spaced apart from one another and joined together by a U-shaped protective bracket (47) which overlaps the electrical parts (2) on the carrier plate (6) in waterrepellent fashion (Figs. 16 and 20 to 22).

14. Plug-in and/or switching device according to claims 1 to 13, characterised in that in each of the two mutually opposed long walls (1a) of the housing (1) there are hollowed at least two grooves (27) which, spaced apart from one another, extend in the direction of elevation from the bottom edge of the housing to the vicinity of the support rim (4), an angular locking member (25) being set in height-adjustable manner and locking in the adjusted elevational position in said grooves (27), and said locking member (25) providing braced attachment of the housing (1) introduced into a cutout (3a) of the operational surface (3) between the support rim (4) resting on the operational surface (3) and the locking member (25) pressing below the operational surface (3) (Figs. 3, 4 and 5).

15. Plug-in and/or switching device according to claim 14, characterised in that each locking member (25) is constituted by an angular part whose horizontal angular leg (28) forms a clamping leg which exerts its action below the operational surface (3) and whose vertical angular leg (29) forms an abutment leg in contact with the inside of the long wall (1a) of the housing, and between the two legs (28, 29) there is provided a crosspiece (30) which passes through the groove (27).

16. Plug-in and/or switching device according to claim 14 and 15, characterised in that on the mutually opposed sides of the grooves there are provided tooth-like engagement members (31), which cooperate with tooth-like engagement members of the crosspiece (30) so as to permit the locking member (25) to slide upwards into the bracing and attachment position and block any downward movement.

17. Plug-in and/or switching device according to claims 14 to 16, characterised in that in extension of its vertical angular leg (29) the locking member (25) has a severable insert-and-tension crosspiece (44) with a gripping ring (45) for attaching the locking member from above and from the inside face of the housing (Figs. 17 to 19).

18. Plug-in and/or switching device according to claims 1 to 17, characterised by a separate cover frame (26) which can be placed onto the operational surface (3) and into which the support rim (4) of the housing (1) can be positioned flush to form a folding connection (33), said cover frame (26) having a rectangular basic form corresponding to the housing (1) and having, on mutually opposed sides of the basic form, straight, arcuate (26b) or angular form edges (Figs. 3 to 5).

19. Plug-in and/or switching device according to claims 1 to 17, characterised in that for each socket-outlet (2) accommodated in the housing (1), a cable lead-through opening (34) is made in the lid (24) in a peripheral area thereof, said cable lead-through opening (34) being obturated by a removable closure plate (36) that has been inserted by means of a latching connection and can be replaced by a hood-shaped cable lead-through part (41) (Figs. 8 to 14), the per se planar closure plate (36) being held in grooves (37) of the lid (24) by crosspieces (38) provided on three sides of the basic form and on its fourth basic form side having a sloping lead-in and lead-out surface (40) as well as a gripping opening (39) for a tool for withdrawing the closure plate (36) (Figs. 9 to 11).

20. Plug-in and/or switching device according to claim 19, characterised in that the hood-shaped cable lead-through part (41) masks the cable lead-through opening (34) on all sides apart from a cable lead-through channel (42) on the side nearest the support rim and is removably held in the grooves (37) of the lid (24) by crosspieces (38) and on the side towards the cable lead-through channel has a lead-in and lead-out surface (40) (Figs. 12 to 14).

21. Plug-in and/or switching device according to claims 1 to 20, characterised in that the housing (1), the cover frame (26), the lid (24), the closure plate (36) and the cable lead-through part (41) are each made in one piece of plastic and in at least one end wall of the housing there is arranged an earth connection (43) accessible from the outside (Figs. 3 to 5).

**Revendications**

1. Dispositif électrique de connexion et/ou de commutation sous forme d'un coffre incorporable dans une surface de travail aux fins d'électrification d'un poste de travail, avec un boîtier allongé (1) présentant plusieurs prises de courant (2) et/ou commutateurs câblés entre eux, caractérisé par le fait qu'une plaque support (6), divisant l'espace intérieur du boîtier en un espace de logement supérieur et un espace de logement inférieur (7, 8), est formé d'une pièce faisant corps avec le boîtier, laquelle plaque support (6) maintient, dans une découpure (5), en position voulue, mais de façon amovible, les prises de courant (2) et/ou commutateurs enfichés, encliquetés ou vissés, faisant saillie dans l'espace de logement inférieur (8) et protégés sur le plan électrique, côté espace de logement supérieur (7), à l'exception de leurs accès, par un cadre (12) prenant appui sur la plaque support (6) et

'que, du côté ouvert pour permettre l'accès aux connecteurs électriques logés dans l'espace supérieur (7) aux fins de prises de courant et de communication, le pourtour du boîtier est pourvu, au moins partiellement, d'une bride d'appui (4), dirigée vers l'extérieur, formée d'une pièce faisant corps avec le boîtier, bride à l'aide de laquelle le coffre est maintenu dans une découpure de la surface de travail (3a).

2. Dispositif électrique de connexion et/ou de commutation selon revendication 1, caractérisé par le fait que la plaque support (6) est façonnée plane en elle-même, faisant corps avec le boîtier, et disposée en-dessous de la moitié de la hauteur du boîtier de forme rectangulaire (1).

3. Dispositif électrique de connexion et/ou de commutation selon les revendications 1 et 2, caractérisé par le fait que des douilles d'appui et de fixation (10), faisant saillie vers le bas, sont formées faisant corps avec la plaque support (6), douilles sur lesquelles le module de prise de courant et/ou de commutation (2), câblé électriquement, introduit par le haut ou par le bas à travers la découpure (5), s'appuie avec ses bords (2a) et est fixé à la plaque support (6) de façon amovible à l'aide de vis (11) traversant les trous pratiqués dans les bords (2a) et pénétrant dans les douilles (10), la partie de l'unité de connexion et/ou de commutation (2) faisant saillie vers le haut au-dessus de la plaque support (6) est recouverte, à l'exception de ses ouvertures d'accès et pièces d'actionnement, par un cadre (12) encliqueté dans cette unité (fig. 1).

4. Dispositif électrique de connexion et/ou de commutation selon les revendications 1 et 2, caractérisé par le fait que le module de connexion et/ou de commutation (2) câblé électriquement est installé dans le boîtier (1), par en-bas, avec une pièce inférieure (13) séparée dans laquelle cette unité (2) est logé et fixé de façon amovible dans le boîtier (1) à l'aide de dispositifs enfichables ou encliquetables, le secteur de l'unité de connexion et/ou de commutation (2), faisant saillie vers le haut, par l découpure (5), hors de la plaque support (6), étant recouvert, à l'exception de ses ouvertures d'accès et ses pièces d'actionnement, par un cadre (12) encliqueté dans cette unité (2).

5. Dispositif électrique de connexion et/ou de commutation selon revendication 4, caractérisé par le fait que la pièce inférieure (13) présente une plaque de fond (14) s'encastrant dans le bâti (1) avec le dessous duquel elle se trouve à niveau, plaque de fond (14) sur laquelle plusieurs douilles d'appui et de fixation (10), dirigées vers le haut, s'élèvent, faisant corps avec cette plaque de fond, les commutateurs et les prises de courant (2) prenant appui ou étant vissés par leurs bords sur ces douilles d'appui et de fixation (10).

6. Dispositif électrique de connexion et/ou de commutation caractérisé par le fait que la partie inférieure (13) est pourvue aux extrémités de manchons (15), formés à partir de sa plaque de fond (14), avec laquelle ils font corps, étant dirigés vers le haut, lesquels manchons (15) embrassent des douilles (16), formées à partir de la plaque support (6), avec laquelle elles font corps, étant dirigées vers le bas, la partie inférieure (13) se trouvant maintenue, de façon amovible, au boîtier (1) à l'aide de vis (17) vissées dans ces manchons (15) et ces douilles (16).

7. Dispositif électrique de connexion et/ou de commutation selon les revendications 3 et 4, caractérisé par le fait que l'unité de prise de courant et commutation (2), insérable par le bas dans la découpure (5) de la plaque support (6) ou installée sur la partie inférieure (13), étant introduite également par le bas dans la découpure (5) de la plaque support, est recouverte par un cadre (12), formé à partir de la partie supérieure de la plaque support (6), avec laquelle il fait corps (Fig. 3).

8. Dispositif électrique de connexion et/ou de commutation selon revendications 1 à 7, caractérisé par le fait que la partie inférieure de la plaque support (6) présente, dans les deux secteurs finaux longitudinaux du bâti, plusieurs douilles (20), façonnées à partir d'elle et faisant corps avec elle, douilles (20) dans lesquelles des bornes de raccord ou des connecteurs électriques multibroches ou mâle-femelle (21) sont maintenus, de façon amovible, à l'aide de fiches et qu'une ouverture d'accès (18) est pratiquée dans chacune des deux parties frontales du boîtier (1), dans le secteur de ces bornes de raccord ou connecteurs électriques multibroches ou mâle-femelle (21) aux fins de raccordement d'une conduite électrique ou d'un second connecteur électrique multibroches (21) (Fig. 1 à 3).

9. Dispositif électrique de connexion et/ou de commutation selon revendications 1 à 8, caractérisé par le fait que le côté supérieur, ouvert, du boîtier est fermé à niveau à l'aide d'un couvercle (24) amovible, inséré à engagement positif dans une surface d'étanchéité (4a), dont il épouse la pente oblique vers le bas de l'espace de logement supérieur (7) (Fig. 1).

10. Dispositif électrique de connexion et/ou de commutation selon revendications 1 à 9, caractérisé par le fait que les deux parties frontales du boîtier (1) présentent des points destinés à la rupture (19) servant à la séparation des parois (19a) et à la formation d'ouvertures (19b) aux fins d'introduction de câbles de communication dans l'espace supérieur (7) (Fig. 2, 3, 5, 15, 16).

11. Dispositif électrique de connexion et/ou de commutation selon revendication 10, caractérisé par le fait que l'ouverture (19b), faisant suite, vers le haut, à la plaque support (6), peut être fermée à l'aide d'une plaque de fermeture (36) ou prolongée vers le haut ou le bas du boîtier (1) par un capuchon de protection (41) installé de façon amovible (Fig. 15).

12. Dispositif électrique de connexion et/ou de commutation selon les revendications de 1 à 11, caractérisé par le fait que dans chacun des deux côtés longitudinaux du boîtier (1), et faisant suite à la plaque support (6) vers le bas, une cuvette (22), s'étendant la hauteur et la longueur totale de l'espace inférieur (8) est façonnée, ouverte vers le haut en direction de ,l'espace supérieur (7), et équipée d'un récipient (23) destiné à recevoir des liquides, ce récipient étant inséré de façon amovible et, de préférence, façonné de sorte à épouser les contours de la cuvette (Fig. 4 et 5).

13. Dispositif électrique de connexion et/ou de commutation selon revendication 12, caractérisé par le fait que les deux récipients (23) sont maintenus à intervalle l'un de l'autre et reliés ensemble à l'aide d'un étrier de protection (47) en forme de U qui recouvre les pièces électriques (2) de la plaque support (6) pour les protéger, de façon étanche, contre les liquides (Fig. 16, 20 à 22).

14. Dispositif électrique de connexion et/ou de commutation selon les revendications de 1 à 13, caractérisé par le fait qu'au moins deux rainures (27), disposées à intervalle l'une de l'autre, s'étendant dans le sens de la hauteur, du bord inférieur du boîtier jusqu'à proximité du bord d'appui (4), sont pratiquées dans chacune des parois longitudinales (1a) opposées du boîtier (1), rainures dans lesquelles un organe de crantage (25) en forme d'équerre, réglable en hauteur, est introduit, étant encliquetable à la hauteur souhaitée et assurant une fixation tendue du boîtier (1), inséré dans une découpure (3a) de la surface de travail (3), entre le bord d'appui (4) reposant sur la surface de travail (3) et l'organe de crantage (25) exerçant pression sous la surface de travail (3) (Fig. 3, 4 et 5).

15. Dispositif électrique de connexion et/ou de commutation selon revendication 14, caractérisé par le fait que chaque organe de crantage (25) est formé par une pièce coudée en équerre, dont le côté horizontal (28) forme un tendeur exerçant pression sous la surface de travail (3) tandis que le côté vertical (29) forme un contre-appui adjacent, à l'intérieur, à la paroi longitudinale (1) du boîtier et qu'un pont (3), s'engageant dans la rainure (27), est prévu entre les deux côté de l'angle (28, 29).

16. Dispositif électrique de connexion et/ou de commutation selon les revendications 14 et 15, caractérisé par le fait que des pièces de crantage (31) dentelées sont prévues aux côtés des rainures vis-à-vis l'un de l'autre, permettant, avec le concours des dents du pont (30), de déplacer l'organe de crantage (25) vers le haut, en vue de l'encliqueter en position de tension et de fixation, tout en interdisant un mouvement rétrograde vers le bas.

17. Dispositif électrique de connexion et/ou de commutation selon les revendications 14 à 16, caractérisé par le fait que l'organe de crantage (25) présente, en prolongation de son côté d'angle vertical (29) une âme d'entrée et de traction (44) séparable, avec poignée annulaire (45) servant à la fixation de l'organe de crantage d'en-haut et du côté intérieur du boîtier (Fig. 17 à 19).

18. Dispositif électrique de connexion et/ou de commutation selon les revendications 1 à 17, caractérisé par le fait qu'un cadre de couverture (26) séparé, dans lequel le bord d'appui (4) du bâti (1) s'insère, à niveau, grâce à un assemblage en feuillure (33) peut être placé sur la surface de travail (3), ce cadre de couverture (26) possédant une forme fondamentale rectangulaire correspondant à celle du boîtier (1) et, aux côtés opposés, des bords rectilignes, en arc (26b) ou angulaires (Fig. 3 à 5).

19. Dispositif électrique de connexion et/ou de commutation selon les revendications 1 à 17, caractérisé par le fait que pour chaque prise de courant (2), logée dans le boîtier (1), une ouverture de passage de câble (34) est pratiquée dans le couvercle (24), disposée dans une section du bord du couvercle, fermée à l'aide plaque de fermeture (36) (Fig. 8 à 14), insérée, de façon amovible, à l'aide d'un encliquetage et remplacable par un pièce de passage de câble en forme de capuchon (41), la plaque de fermeture (36), plane en elle-même, étant maintenue dans des rainures (37) du couvercle (24), à l'aide de trois saillies (38), prévues sur trois des côtés de sa forme fondamentale, tandis que le quatrième côté présente une surface oblique d'entrée et de sortie (40) ainsi qu'une ouverture de saisie (39) pour un auxiliaire d'enlèvement de la plaque de fermeture (36) (Fig. 9 à 11).

20. Dispositif électrique de connexion et/ou de commutation selon revendication 19, caractérisé par le fait que la pièce de passage de câble en forme de capuchon (41) recouvre l'ouverture de passage de câble (34) de tous côtés, à l'exception d'un canal de passage de câble (42) et est maintenue, de façon amovible, dans les rainures (37) du couvercle (24) à l'aide de saillies (38) et est pourvue, côté canal de passage de câble, d'une surface d'entrée et de sortie (40) (Fig. 12 à 14).

21. Dispositif électrique de connexion et/ou de commutation selon les revendications 1 à 20, caractérisé par le fait que le boîtier (1), le cadre de couverture (26), le couvercle (24), la plaque de fermeture (36) et la pièce de passage de câble (41) sont exécutés chacun d'une pièce en matière plastique et qu'une prise de terre (43), accessible de l'extérieur, est disposée dans une partie frontale au moins du bâti (Fig. 3 à 5).

Fig.1

EP 0197186 B1

Fig.2

EP 0197186 B1

Fig. 3

EP 0197186 B1

Fig. 4

EP 0197186 B1

Fig. 5

Fig. 7
I-I

Fig. 8

Fig. 6

EP 0197186 B1

Fig. 9

Fig.10

Fig.11

Fig.12

Fig.13

Fig.14

Fig.15

Fig.16

EP 0 197 186 B1

Fig.17

Fig.18

Fig.19

Fig.20

EP 0 197 186 B1

Fig.22

47

48

23

23

48

Fig.21

48

23

47

48